# EUROPEAN PATENT APPLICATION

(11) **EP 3 982 422 A1**
(43) Date of publication of application: **13.04.2022**
(21) Application number: 19931955.9
(22) Date of filing: 13.11.2019
(51) Int. Cl.: H01L 31/048, H01L 51/44

(54) **SOLAR CELL MODULE**

(30) Priority: 05.06.2019 JP 2019105511
(71) Applicant: Panasonic Intellectual Property Management Co., Ltd., Osaka-shi, Osaka 540-6207 (JP)
(72) Inventor: YAMAMOTO Teruaki, Osaka-shi (JP); NEGAMI Takayuki, Osaka-shi (JP)
(74) Representative: Grünecker Patent- und Rechtsanwälte PartG mbB
(86) International application number: PCT/JP2019/044538
(87) International publication number: WO 2020/246057

(57) **Abstract**

The present disclosure provides a solar cell module that can have high durability. The solar cell module (100) of the present disclosure includes: a first substrate (1); a second substrate (2) positioned so as to face the first substrate (1); a solar cell (3) disposed on the first substrate (1) so as to be interposed between the first substrate (1) and the second substrate (2); a filler (4) that fills a space between the first substrate (1) and the second substrate (2); and a protective layer (5) disposed on a principal surface (3a) of the solar cell (3) that faces the second substrate (2). The solar cell (3) has a multilayer structure including a photoelectric conversion layer (6) containing a perovskite compound, a hole transport layer (7), and an electron transport layer (8). The protective layer (5) contains a polyimide. The protective layer (5) includes a first region (9) that covers the principal surface (3a) of the solar cell (3) and a second region (10) in which the principal surface (3a) is exposed. A plurality of the first regions (9) or a plurality of the second regions (10) are arranged separately from each other in the protective layer (5).

## Description

### Technical Field

The present disclosure relates to a solar cell module.

### Background Art

In recent years, research and development is being conducted on perovskite solar cells. The perovskite solar cells use, as a light absorption material, a compound having a perovskite crystal structure represented by a composition formula of ABX₃ (where A is a monovalent cation, B is a divalent cation, and X is a halogen anion) or a compound having a crystal structure similar to the perovskite crystal structure. In the present description, the solar cell using the perovskite compound is referred to as a "perovskite solar cell."

NPL 1 discloses the basic structure of a perovskite solar cell. The perovskite solar cell having the basic structure includes, in the following order: a transparent electrode; an electron transport layer, a light absorption layer that uses perovskite crystals and absorbs light to cause photocharge separation (this layer is hereinafter referred to as a "perovskite layer"); a hole transport layer; and a current collector electrode. Specifically, the electron transport layer (n), the perovskite layer (i), and the hole transport layer (p) are stacked in this order from the transparent electrode side. This structure is referred to as an n-i-p structure or a forward stacking structure.

NPL 2 discloses a perovskite solar cell having a structure including a hole transport layer, a perovskite layer, and an electron transport layer that are stacked in this order from a transparent electrode side. This structure is referred to as a pi-n structure or a reverse stacking structure.

Solar cells are devices that generate electric power when they receive sunlight, i.e., devices that utilize sunlight as an energy source. Therefore, the solar cells are generally installed outside for use. Thus, the solar cells require a sealing structure called a solar cell module so that the solar cells can withstand an outdoor environment such as high temperature, wind and rain, etc.

### Citation List

### Non Patent Literature

NPL 1: Julian Burchcka and six others, "Nature" (UK), 2013, July Vol. 499, p. 316-319
NPL 2: Wei Chen and ten others, "SCIENCE" (US), 2015, November, Vol. 350, No. 6263, p. 944-948

### Summary of Invention

### Technical Problem

It is an object of the present disclosure to provide a solar cell module with high durability.

### Solution to Problem

The solar cell module of the present disclosure includes:
a first substrate;
a second substrate positioned so as to face the first substrate;
a solar cell disposed on the first substrate so as to be interposed between the first substrate and the second substrate;
a filler that fills a space between the first substrate and the second substrate; and
a protective layer disposed on a principal surface of the solar cell, the principal surface facing the second substrate,
wherein the solar cell has a multilayer structure including a photoelectric conversion layer containing a perovskite compound, a hole transport layer, and an electron transport layer,
wherein the protective layer contains a polyimide,
wherein the protective layer includes a first region that covers the principal surface of the solar cell and a second region in which the principal surface is exposed, and
wherein a plurality of the first regions or a plurality of the second regions are arranged separately from each other in the protective layer.

### Advantageous Effects of Invention

The present disclosure provides a solar cell module with high durability.

### Brief Description of Drawings

[Fig. 1A] Fig. 1A is a cross-sectional view schematically showing a solar cell module in an embodiment of the present disclosure.
[Fig. 1B] Fig. 1B is a cross-sectional view of a protective layer in a plane on chain line I-I in the solar cell module shown in Fig. 1A.
[Fig. 2A] Fig. 2A is a cross-sectional view schematically showing a modification of the solar cell in the embedment of the present disclosure.
[Fig. 2B] Fig. 2B is a cross-sectional view of a protective layer in a plane on chain line II-II in the solar cell module shown in Fig. 2A.
[Fig. 3] Fig. 3 is a cross-sectional view schematically showing a solar cell module in a first comparative embodiment.
[Fig. 4A] Fig. 4A is a cross-sectional view schematically showing a solar cell module in a second comparative embodiment.
[Fig. 4B] Fig. 4B is a cross-sectional view of a protective layer in a plane on chain line III-III in the solar cell module shown in Fig. 4A.
[Fig. 5A] Fig. 5A is a cross-sectional view schematically showing a solar cell module in a third comparative embodiment.
[Fig. 5B] Fig. 5B is a cross-sectional view of a protective layer in a plane on chain line IV-IV in the solar cell module shown in Fig. 5A.
[Fig. 6] Fig. 6 is a graph showing the relation between the area fraction of second regions and the retention ratio of a fill factor (FF).
[Fig. 7] Fig. 7 is a graph showing the relation between the area fraction of the second regions and the retention ratio of open circuit voltage (Voc).
[Fig. 8] Fig. 8 is a graph showing the relation between the area fraction of the second regions and the retention ratio of the open circuit voltage (Voc).
[Fig. 9] Fig. 9 is a graph showing the relation between the area fraction of the second regions and the retention ratio of the open circuit voltage (Voc).
[Fig. 10] Fig. 10 is a graph showing the relation between the area fraction of the second regions and the retention ratio of the open circuit voltage (Voc).
[Fig. 11] Fig. 11 is a graph showing the relation between the effective area fraction of the second regions and the retention ratio of the open circuit voltage (Voc).
[Fig. 12] Fig. 12 is a graph showing the relation between the effective area fraction of the second regions and the retention ratio of the open circuit voltage (Voc).

### Description of Embodiment

An embodiment of the present disclosure will be described in detail with reference to the drawings.

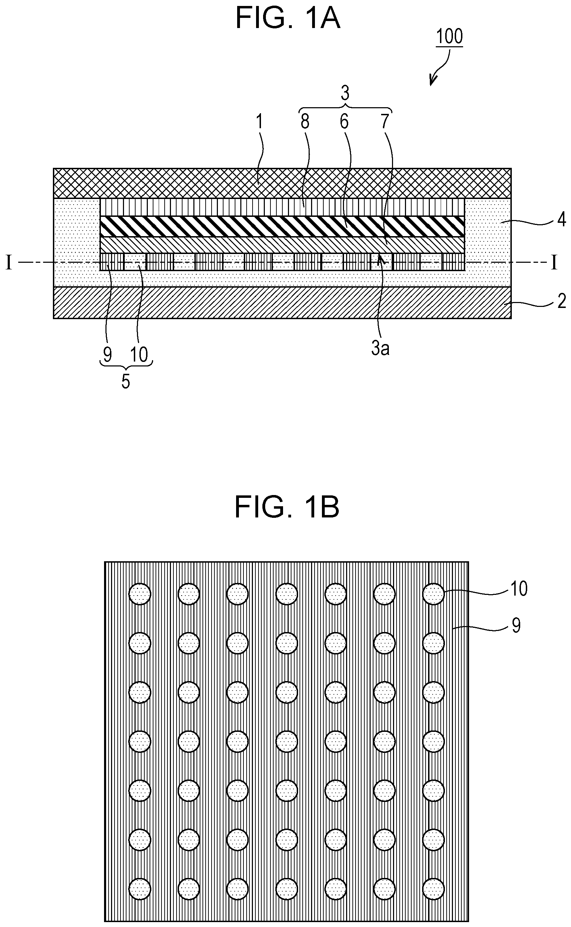

Fig. 1A is a cross-sectional view schematically showing a solar cell module 100 in an embodiment. Fig. 1B is a cross-sectional view of a protective layer in a plane on chain line I-I in the solar cell module 100 shown in Fig. 1A.

As shown in Fig. 1A, the solar cell module 100 includes a first substrate 1, a second substrate 2, a solar cell 3, a filler 4, and a protective layer 5. The second substrate 2 is positioned so as to face the first substrate 1. The solar cell 3 is disposed on the first substrate 1 so as to be interposed between the first substrate 1 and the second substrate 2. The filler 4 fills a space between the first substrate 1 and the second substrate 2. The protective layer 5 is disposed on a principal surface 3a of the solar cell 3 that faces the second substrate 2.

The solar cell 3 has a multilayer structure including a photoelectric conversion layer 6 containing a perovskite compound, a hole transport layer 7, and an electron transport layer 8. For example, in the solar cell 3, the electron transport layer 8, the photoelectric conversion layer 6, and the hole transport layer 7 are stacked in this order. The solar cell 3 may include an additional layer. For example, a porous layer may be disposed between the electron transport layer 8 and the photoelectric conversion layer 6. The solar cell 3 further includes electrodes used as output terminals although these electrodes are not shown in Fig. 1. Specifically, the solar cell 3 may have a multilayer structure including a first electrode (not shown), the electron transport layer 8, the photoelectric conversion layer 6, the hole transport layer 7, and a second electrode (not shown) that are stacked in this order.

The protective layer 5 includes a first region 9 that covers the principal surface 3a of the solar cell 3 and second regions 10 in which the principal surface 3a is exposed. The protective layer 5 contains a polyimide. Specifically, the first region 9 of the protective layer 5 is formed of a material containing the polyimide.

In the example shown in Figs. 1A and 1B, The second regions 10 are arranged separately from each other in the protective layer 5. In this case, the second regions 10 in the protective layer 5 are a plurality of apertures passing through the protective layer 5 in its thickness direction and arranged separately from each other. More specifically, in this case, the protective layer 5 is formed from a thin film containing, for example, a polyimide. As shown in Fig. 1A, the thin film has the plurality of apertures passing through the thin film in its thickness direction and arranged separately from each other as the second regions 10. No particular limitation is imposed on the shape of the apertures, and the apertures may have a circular shape as shown in Fig. 1B or may have, for example, a polygonal shape. The plurality of apertures may be arranged at substantially regular intervals on the principal surface 3a of the solar cell 3.

Next, the basic operational effects of the components of the solar cell module 100 in the present embodiment will be described.

When the solar cell 3 is irradiated with light, the photoelectric conversion layer 6 absorbs the light, and excited electrons and holes are generated. The excited electrons move to the electron transport layer 8. The holes generated in the photoelectric conversion layer 6 move to the hole transport layer 7. The first electrode connected to the electron transport layer 8 serves as a negative electrode, and the second electrode connected to the hole transport layer 7 serves as a positive electrode. An electric current can be drawn from the negative and positive electrodes.

In the solar cell module 100, the space between the first substrate 1 and the second substrate 2 is filled with the filler 4. By providing the filler 4, the mechanical strength of the solar cell module 100 can improved, and the displacement of the components thereinside can be prevented.

By disposing the protective layer 5 on the principal surface 3a of the solar cell 3, delamination at the interface between the photoelectric conversion layer 6 and the hole transport layer 7 or the interface between the photoelectric conversion layer 6 and the electron transport layer 8 may be prevented. This operational effect will be described in more detail. When the space between the first substrate 1 and the second substrate 2 is filled with the filler 4 to integrate them together, a heat pressure-bonding method, for example, is generally used. In this case, first, a multilayer body in which the material of the filler 4 is disposed between the first substrate 1 with the solar cell 3 disposed thereon and the second substrate 2 disposed so as to face the first substrate 1 is produced. Next, the material of the filler 4 is heated and melted, and the multilayer body as a whole is subjected to pressure bonding to thereby integrate the first substrate 1, the solar cell 3, the filler 4, and the second substrate 2 together. In the solar cell 3, the bonding force at the interface between two layers may be weak. In this case, when the entire principal surface 3a of the solar cell 3 is in contact with the filler 4, delamination may occur at the weakly bonded interface because, for example, the interface is dragged by the flow of the filler 4 when the filler 4 is heated and melted to pressure-bond the multilayer body. This interfacial delamination tends to occur at the interface between the photoelectric conversion layer 6 and the hole transport layer 7 or at the interface between the photoelectric conversion layer 6 and the electron transport layer 8. However, in the solar cell module 100 in the present embodiment, the protective layer 5 is disposed between the principal surface 3a of the solar cell 3 and the filler 4. Since the protective layer 5 contains a polyimide, its heat resistance is high, and its abrasion resistant is also high. Therefore, even when the multilayer body is pressure-bonded with the material of the filler heated and melted, the protective layer 5 is interposed between the principal surface 3a of the solar cell 3 and the filler 4. In this case, the occurrence of delamination at an interface in the solar cell 3 that is caused, for example, by the flow of the filler 4 dragging the interface can be prevented.

The second regions 10 which are arranged separately from each other and in which the principal surface 3a of the solar cell 3 is exposed are provided in the protective layer 5. The second regions 10 can reduce a reduction in the characteristics of the solar cell that is caused by desorbed gas staying at high concentration on the surface of the solar cell 3. The desorbed gas is derived from the material forming the protective layer 5, i.e., the material forming the first region 9 and containing a polyimide. The desorbed gas diffuses, for example, throughout the entire the filler 4.

As described above, the protective layer 5 allows prevention of the interfacial delamination at the interfaces between the layers in the multilayer structural body forming the solar cell 3 and prevention of deterioration due to the desorbed gas simultaneously.

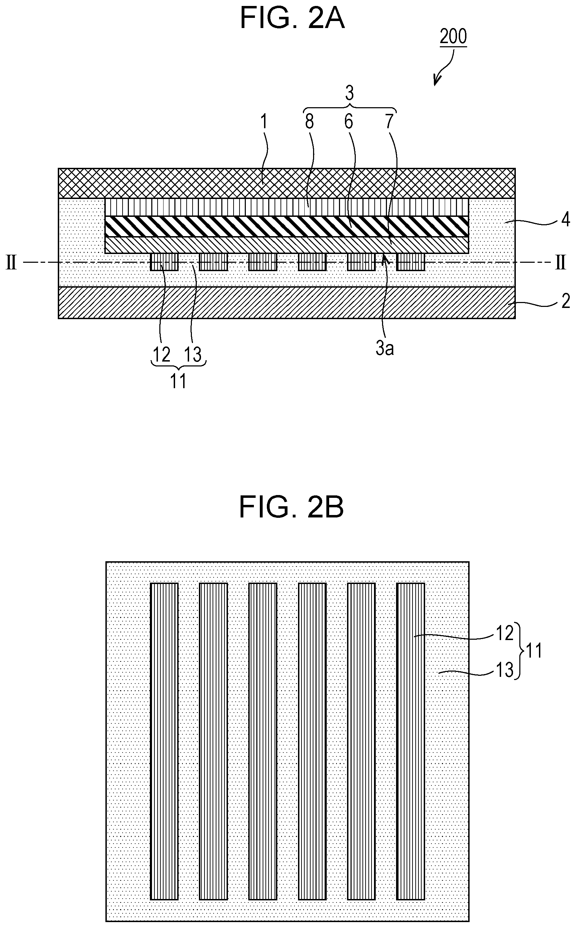

The structure of the protective layer 5 is not limited to the structure shown in Figs. 1A and 1B. Fig. 2A is a cross-sectional view schematically showing a solar cell module 200 that is a modification of the solar cell module in the present embodiment. Fig. 2B is a cross-sectional view of a protective layer in a plane on chain line II-II in the solar cell module 200 shown in Fig. 2A. The protective layer may be a protective layer 11 including first regions 12 arranged separately from each other and a second region 13 as shown in Figs. 2A and 2B. The first regions 12 may be formed of a plurality of thin films containing a polyimide. No particular limitation is imposed on the shape of the thin films arranged separately from each other. The thin films may have a strip shape shown in Fig. 2B or may have a polygonal shape, etc. The plurality of thin films may be arranged at substantially regular intervals on the principal surface 3a of the solar cell 3.

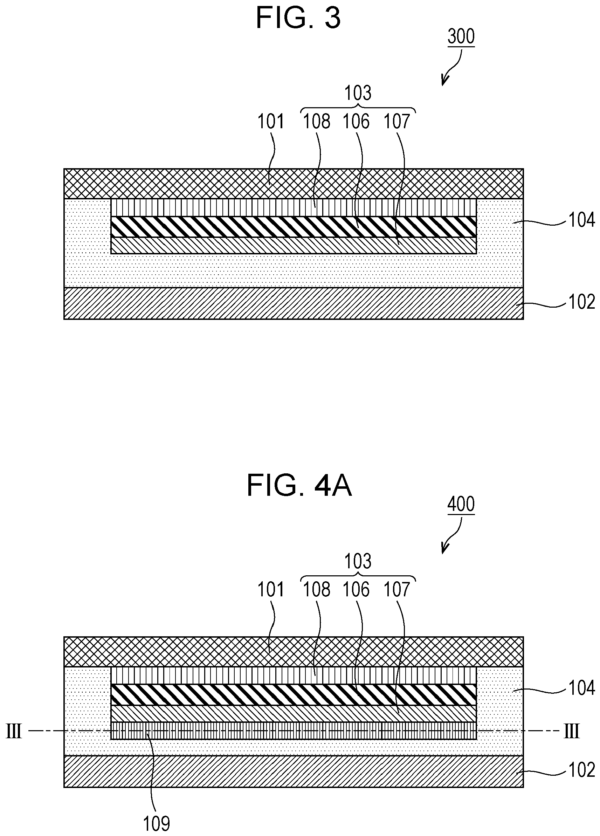

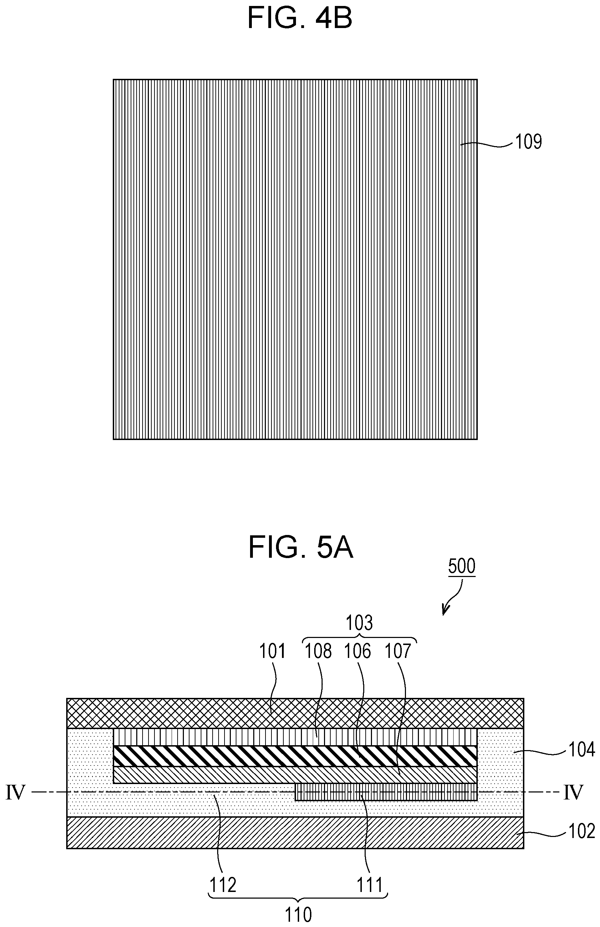

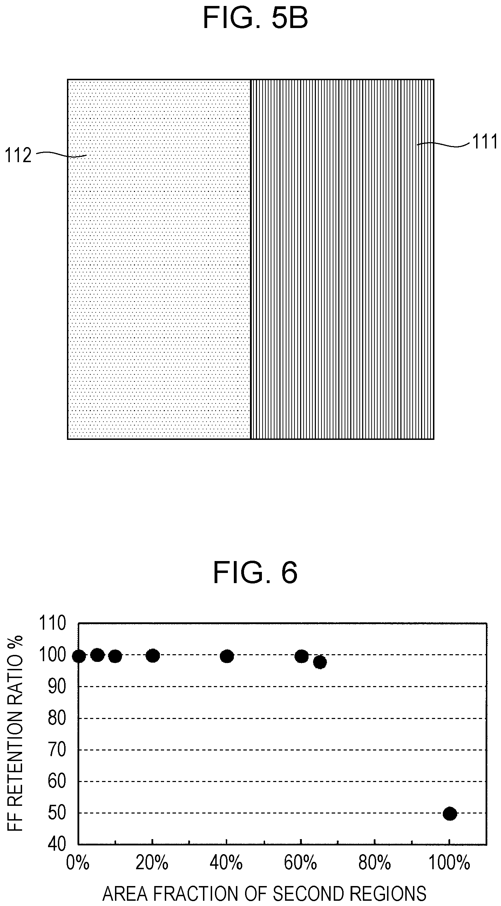

The difference in the effect due to the differences in arrangement and formation of the first region(s) 9, 12 and the second region(s) 10, 13 in the protective layer 5, 11 will be described with reference to solar cell modules in comparative embodiments. Fig. 3 is a cross-sectional view schematically showing a solar cell module 300 in a first comparative embodiment. Fig. 4A is a cross-sectional view schematically showing a solar cell module 400 in a second comparative embodiment. Fig. 4B is a cross-sectional view of a protective layer in a plane on chain line III-III in the solar cell module 400 shown in Fig. 4A. Fig. 5A is a cross-sectional view schematically showing a solar cell module 500 in a third comparative embodiment. Fig. 5B is a cross-sectional view of a protective layer in a plane on chain line IV-IV in the solar cell module 500 shown in Fig. 5A.

The solar cell module 300 shown in Fig. 3 has a structure in which no protective layer is present on the principal surface of the solar cell and the solar cell is in contact with the filler. A first substrate 101, a second substrate 102, a solar cell 103, a filler 104, a photoelectric conversion layer 106, a hole transport layer 107, and an electron transport layer 108 shown in Fig. 3 correspond to the first substrate 1, the second substrate 2, the solar cell 3, the filler 4, the photoelectric conversion layer 6, the hole transport layer 7, and the electron transport layer 8, respectively, of the solar cell module 100, 200. Therefore, the detailed description of these components will be omitted. The same applies to Figs. 4 and 5 below. In the structure of the solar cell module 300, delamination may occur at the interface between the photoelectric conversion layer 106 and the hole transport layer 107 or the electron transport layer 108. When the delamination occurs, the diode characteristics of the solar cell 103 deteriorate. Therefore, the occurrence of the delamination causes a reduction in the rectification ability.

The solar cell module 400 shown in Figs. 4A and 4B includes a protective layer 109 different from the protective layer in the solar cell module 100 shown in Figs. 1A and 1B and the protective layer in the solar cell module 200 shown in Figs. 2A and 2B. The protective layer 109 of the solar cell module 400 includes no second regions and includes only a first region. Specifically, the solar cell module 400 has a structure in which the entire principal surface of the solar cell 103 that serves as its power generation region is fully covered with the protective layer 109. In this structure, desorbed gas derived from the material of the protective layer 109 stays at high concentration on the surface of the solar cell 103. The gas staying on the surface causes a reduction the characteristics of the solar cell.

The solar cell module 500 shown in Figs. 5A and 5B includes a protective layer 110 different from the protective layer in the solar cell module 100 shown in Figs. 1A and 1B and the protective layer in the solar cell module 200 shown in Figs. 2A and 2B. The protective layer 110 of the solar cell module 500 includes a first region 111 and a second region 112. However, in the protective layer 110, each of the first region 111 and the second region 112 is not regions arranged separately from each other. Specifically, the first region 111 and the second region 112 are each formed as a single continuous region. In this case, part of the principal surface of the solar cell 103 that serves as the power generation region is fully covered with the first region 111 as shown in Figs. 5A and 5B. In this region covered with the first region 111, desorbed gas derived from the material forming the first region 111 of the protective layer 110 stays at high concentration on the surface of the solar cell 103. The gas staying on the surface causes a reduction in the characteristics of the solar cell.

The solar cell module 100, 200 in the present embodiment has the structure in which the protective layer disposed on the principal surface of the solar cell that faces the second substrate includes the first region(s) covering the principal surface of the solar cell and the second region(s) in which the principal surface is exposed. In this structure, the first regions or the second regions are arranged separately from each other. In the solar cell module 100, 200 having the above structure, the effect of preventing interfacial delamination by the first region(s) and the effect of preventing degradation due to desorbed gas by the second region(s) can be achieved simultaneously.

The solar cell module 100, 200 in the present embodiment can be produced, for example, by the following method.

First, the first electrode is formed on a surface of the first substrate 1. Next, the electron transport layer 8 is formed on the first electrode on the first substrate 1 by, for example, a sputtering method. Next, the photoelectric conversion layer 6 is formed on the electron transport layer 8 by, for example, a coating method. Next, the hole transport layer 7 is formed on the photoelectric conversion layer 6 by, for example, a coating method. Next, the second electrode is formed on the hole transport layer 7 by, for example, vapor deposition.

The solar cell 3 can be formed on the first substrate 1 through the above steps.

Next, the protective layer 5, 11 is formed on the solar cell 3. When a protective layer such as the protective layer 5 in which the second regions are arranged separately from each other is formed, for example, a thin film containing a polyimide and having formed therein a plurality of apertures passing through the thin film and arranged separately from each other is prepared. The protective layer 5 can be formed by placing this thin film on the solar cell 3. When a protective layer such as the protective layer 11 in which the second regions are arranged separately from each other is formed, for example, a plurality of thin films containing a polyimide and having a prescribed shape (e.g., a strip shape) are prepared. The protective layer 11 can be formed by arranging the thin films on the solar cell 3 in a prescribed pattern.

Next, the first substrate 1, the second substrate 2 positioned so as to face the first substrate 1, and the filler 4 disposed between the first substrate 1 and the second substrate 2 are integrated by integral forming such as heat pressure-bonding. The solar cell module 100, 200 can thereby be obtained.

The components of the solar cell module 100, 200 will be described in detail.

### [First substrate 1]

The first substrate 1 is disposed on the light receiving side of the solar cell module 100, 200. The first substrate 1 has, for example, water vapor barrier properties and light transmitting properties. The first substrate 1 may be transparent. The first substrate 1 plays a role in physically holding the layers forming the solar cell 3 as films when the solar cell module 100,200 is produced. The first substrate 1 is, for example, a glass substrate or a plastic substrate. The plastic substrate may be a plastic film.

### [Second substrate 2]

The second substrate 2 is positioned so as to face the first substrate 1 of the solar cell module 100, 200. The second substrate 2 has, for example, water vapor barrier properties. The second substrate 2 also plays a role in protecting the solar cell 3. The second substrate 2 can prevent physical damage to the solar cell 3 due to an external factor such as sand particles. The second substrate 2 is, for example, a glass substrate or a plastic substrate. The plastic substrate may be a plastic film. It is not always necessary that the second substrate 2 have light-transmitting properties. Therefore, for example, an Al vapor-deposited film can be used as the second substrate 2.

### [Photoelectric conversion layer 6]

The photoelectric conversion layer 6 contains, as a light absorption material, a compound having a perovskite structure represented by a composition formula of ABX₃. A is a monovalent cation. A is, for example, a monovalent cation such as an alkali metal cation or an organic cation. Specific examples of A include a methylammonium cation (CH₃NH₃⁺), a formamidinium cation (NH₂CHNH₂⁺), a cesium cation (Cs⁺), and a rubidium cation (Rb⁺). B is a divalent cation. B is, for example, a divalent cation of a transition metal or any of group 13 to group 15 elements. Specific examples of B include Pb₂⁺, Ge₂⁺, and Sn₂⁺. X is a monovalent anion such as a halogen anion. The A, B, or X sites may be occupied by a plurality of types of ions. Specific examples of the compound having the perovskite structure include CHsNHsPbls, CH₃CH₂NH₃PbI₃, NH₂CHNH₂PbI₃, CHsNHsPbBrs, CH₃NH₃PbCl₃, CsPbI₃, CsPbBrs, RbPbI₃, and RbPbBrs. The photoelectric conversion layer 6 may be formed of a perovskite compound that is a structural body similar to the compound having the perovskite structure represented by the composition formula ABX₃. Examples of the similar structural body include a structural body that is a perovskite compound including halogen anion defects and a structural body that is a perovskite compound in which the monovalent cation or the halogen anion includes a plurality of types of elements.

The thickness of the photoelectric conversion layer 6 is, for example, equal to or more than 100 nm and equal to or less than 1000 nm. The thickness of the photoelectric conversion layer 6 may depend on the amount of light absorption by the photoelectric conversion layer 6. The photoelectric conversion layer 6 can be formed by a coating method using a solution or a co-deposition method. The photoelectric conversion layer 6 may be partially mixed with the electron transport layer 8.

### [Hole transport layer 7]

The hole transport layer 7 is formed of, for example, an organic semiconductor or an inorganic semiconductor. The hole transport layer 7 may have a structure in which layers formed of the same material are stacked or may have a structure in which layers formed of different materials are stacked alternately. Examples of the organic semiconductor include polytriallylamine (PTAA), 2,2',7,7'-tetrakis(N,N'-di-p-methoxyphenylamine)-9-9'-spirobifluorene (Spiro-OMeTAD), and poly(3,4-ethylenedioxythiophene) (PEDOT). Examples of the inorganic semiconductors include p-type inorganic semiconductors. Examples of the p-type inorganic semiconductors include CuO, Cu₂O, CuSCN, molybdenum oxide, and nickel oxide.

### [Electron transport layer 8]

The electron transport layer 8 contains a semiconductor. The electron transport layer 8 may be formed of a semiconductor having a bandgap equal to or more than 3.0 eV. By forming the electron transport layer 8 using a semiconductor having a bandgap equal to or more than 3.0 eV, visible light and infrared light are allowed to pass through to the photoelectric conversion layer 6. Examples of such a semiconductor include n-type organic semiconductors and n-type inorganic semiconductors.

Examples of the n-type organic semiconductors include imide compounds, quinone compounds, fullerenes, and fullerene derivatives. Examples of the n-type inorganic semiconductors include metal oxides and perovskite oxides. Examples of the metal oxides include oxides of Cd, Zn, In, Pb, Mo, W, Sb, Bi, Cu, Hg, Ti, Ag, Mn, Fe, V, Sn, Zr, Sr, Ga, Si, and Cr. Specific examples include titanium oxide (i.e., TiO₂). Examples of the perovskite oxides include SrTiO₃ and CaTiO₃.

### [Filler 4]

The filler 4 used may be a well-known filler for solar cell modules. Examples of the filler 4 include ethylene-vinyl acetate (EVA) and polyolefin (PO).

### [Protective layer 5, 11]

As described above, the protective layer 5, 11 includes the first region(s) 9, 12 covering the principal surface 3a of the solar cell 3 and the second region(s) 10, 13 in which the principal surface 3a of the solar cell 3 is exposed. The material of the protective layer 5, 11, i.e., the material of the first region(s) 9, 12, contains a polyimide. The polyimide is electrically insulative and has excellent flexibility, heat resistance, and chemical resistance. The first region(s) 9, 12 formed of such a material can reduce the propagation of stress caused by deformation of the filler 4 to the interfaces between the layers included in the solar cell 3. Therefore, the first region(s) 9, 12 can prevent interfacial delamination in the solar cell 3.

In the second region(s) 10, 13 of the protective layer 5, 11, the principal surface 3a of the solar cell 3 is exposed. In other words, the second region(s) 10, 13 is(are) a region(s) of the protective layer 5, 11 in which the principal surface 3a of the solar cell 3 is not covered. Specifically, the second region(s) 10, 13 play(s) a role in allowing the principal surface 3a to be partially exposed while the principal surface 3a is prevented from being fully covered with the first region(s) 9, 12. Therefore, the second region(s) 10, 13 can prevent a reduction in the characteristics of the solar cell that is caused by desorbed gas derived from the material of the first region(s) 9, 12 and staying at high concentration on the surface of the solar cell 3. The above effect can be obtained by the second regions 10 composed of apertures formed in the thin film and also by the second region 13 provided as a region excluding the first regions arranged separately from each other.

The area fraction of the second region(s) 10, 13 in the protective layer 5, 11 may be, for example, equal to or more than 7% and equal to or less than 60%. When the area fraction of the second region(s) is equal to or more than 7%, the stay of the desorbed gas derived from the first region(s) 9, 12 can be prevented sufficiently. When the area fraction of the second region(s) is equal to or less than 60%, interfacial delamination in the solar cell 3 is prevented sufficiently, and the mechanical strength of the protective layer 5, 11 can be maintained sufficiently.

The effective area fraction of the second region(s) 10, 13 in the protective layer 5, 11 may be, for example, equal to or more than 24% and equal to or less than 91%. When the effective area fraction of the second region(s) is equal to or more than 24%, the stay of the desorbed gas derived from the first region(s) 9, 12 can be prevented sufficiently. When the effective area fraction of the second region(s) is equal to or less than 91%, interfacial delamination in the solar cell 3 is prevented sufficiently, and the mechanical strength of the protective layer 5, 11 can be maintained sufficiently. The effective area of the second region(s) will be described. The protective layer may have second regions composed of a plurality of apertures arranged separately from each other or a second region excluding first regions arranged separately from each other. In any of these structures, it may be necessary that, in order to allow a desorbed gas molecule to escape through the second region(s), the distance from the position of the desorbed gas molecule to the second region(s) be equal to or less than a certain distance. The certain distance is an effective distance that allows the desorbed gas molecule to escape through the second region(s). The effective distance is, for example, 0.2 mm. For example, when the second regions are apertures, gas molecules whose distances from the edges of the apertures are equal to or less than the effective distance may be allowed to escape through the apertures. Therefore, the effective area of a second region is defined as an area obtained by increasing the area of the second region by an area corresponding to the effective distance. For example, when each aperture has a circular shape and the effective distance is 0.2 mm, an area computed using "the diameter of the aperture + 0.4 mm" as the diameter of the aperture is defined as the effective area of the aperture. Similarly, in the case of the second region excluding the first regions arranged separately from each other, the effective area of the second region can be determine by extending the second region by 0.2 mm outward from its edges (toward the first regions). The area fraction of the second region(s) in the protective layer can be determined using the thus-computed effective area(s) of the second region(s), and the value obtained is used as the effective area fraction.

Since the desorbed gas does not stay at high concentration between the filler 4 and the principal surface 3a of the solar cell 3, the second region(s) 10, 13 may be partially or fully filled with the filler 4. The second region(s) 10, 13 may have any shape so long as the above conditions are satisfied.

### (EXAMPLES)

The present disclosure will be described in more detail with reference to the following Examples.

Solar cell modules in Examples 1 to 9 and Comparative Examples 1 to 3 were produced, and the characteristics of the solar cell modules were evaluated.

First, the structures of the solar cell modules in the Examples and Comparative Examples and their production methods will be described.

### [Example 1]

The solar cell module in Example 1 has the same structure as that of the solar cell module 100 shown in Figs. 1A and 1B. The materials, sizes, and thicknesses of the components of the solar cell module in Example 1 are shown below.

First substrate 1: glass substrate with a fluorine-doped SnO₂ layer (manufactured by Nippon Sheet Glass Co., Ltd., thickness: 0.7 mm, surface resistance: 10 Ω/sq.)
Electron transport layer 8: titanium oxide (thickness: 30 nm ), porous titanium oxide (thickness: 200 nm)
Photoelectric conversion layer 6: CH₃NH₃PbI₃ (thickness: 300 nm)
Hole transport layer 7: PTAA (manufactured by Aldrich)
Second substrate 2: Al vapor-deposited film (PET (thickness: 50 µm)/Al (thickness: 7 µm)/PET (thickness: 50 µm))
Filler 4: polyolefin (thickness: 450 µm)
First region 9 of protective layer 5: polyimide tape (P-221 manufactured by NITTO DENKO Corporation) (thickness: 25 µm)
Second regions 10 of protective layer 5: area fraction 10%, effective area fraction 24%, diameter of apertures 0.71 mm, center-to-center distance of apertures 2 mm

The method for producing the solar cell module in Example 1 is as follows.

An electrically conductive glass substrate having a thickness of 0.7 mm and including a fluorine-doped SnO₂ layer on a principal surface was prepared. This substrate was used as the first substrate 1. The fluorine-doped SnO₂ layer on the electrically conductive glass substrate was used as the first electrode.

A titanium oxide layer with a thickness of about 30 nm and a porous titanium oxide layer with a thickness of 0.2 µm were formed as the electron transport layer 8 on the first electrode of the first substrate 1. The titanium oxide layer was formed on the first electrode of the first substrate 1 by sputtering. The porous titanium oxide layer was formed by applying a titanium oxide paste to the titanium oxide layer, drying the paste, and then firing the dried film in air at 500°C for 30 minutes. The titanium oxide paste was prepared by dispersing a high-purity titanium oxide powder with an average primary particle diameter of 20 nm in ethyl cellulose.

Next, the photoelectric conversion layer 6 was formed on the electron transport layer 8. A dimethyl sulfoxide (DMSO) solution containing PbI₂ at a concentration of 1 mol/L and methylammonium Iodide at a concentration of 1 mol/L was prepared. This solution was applied to the electron transport layer 8 by spin coating to form a coating film. Then the coating film formed was heat-treated on a hot plate at 130°C to thereby obtain a CH₃NH₃PbI₃ layer having the perovskite structure and used as the photoelectric conversion layer 6.

Next, a toluene solution containing PTAA at a concentration of 10 mg/mL, lithium bis(fluorosulfonyl)imide (LiTFSI) at a concentration of 5 mmol/L, and tert-butylpyridine (tBP) at a concentration of 6 µL/mL was applied to the photoelectric conversion layer 6 by spin coating to thereby obtain the hole transport layer 7.

Gold used for the second electrode was evaporated to a thickness of 80 nm onto the hole transport layer 7.

The solar cell 3 was thereby formed on the first substrate 1.

Next, the protective layer 5 was formed on the solar cell 3. A polyimide tape having a plurality of apertures passing therethrough in its thickness direction and arranged separately from each other was prepared. Each of the apertures has a circular shape with a diameter of 0.71 mm. The plurality of apertures were formed such that the center-to-center distance between the apertures was 2 mm. The apertures were formed by pressing a die having conical protrusions arranged at regular intervals against the polyimide tape. In the protective layer 5, the area fraction of the apertures, i.e., the area fraction of the second regions, was 10%. The effective diameter of the apertures was 0.71 mm + 0.4 mm = 1.11 mm. The effective area fraction of the apertures, i.e., the effective area fraction of the second regions, was 24%. The polyimide tape with the apertures formed therein was placed on the solar cell 3 to thereby form the protective layer 5.

Next, a multilayer body including the first substrate 1, an Al vapor-deposited film used as the second substrate 2 disposed so as to face the first substrate 1, and a polyolefin sheet disposed between the first substrate 1 and the second substrate 2 and used as the filler 4 was subjected to heat pressure-bonding using a vacuum lamination method to thereby obtain the solar cell module 100. The pressure bonding was performed by degassing the multilayer body at 130°C for 180 seconds and pressing the multilayer body for 300 seconds.

### [Examples 2 to 8]

Solar cell modules in Examples 2 to 8 were produced in the same manner as that for the solar cell module in Example 1 except that the diameter of the apertures in the protective layer 5, the center-to-center distance of the apertures, and the area fraction of the second regions were changed to values shown in Table 1.

### [Example 9]

A solar cell module in Example 9 has the same structure as the structure of the solar cell module 200 shown in Figs. 2A and 2B. The solar cell module in Example 9 was produced using the same procedure as that for the solar cell module in Example 1 except for the structure of the protective layer 11. Therefore, only the protective layer 11 of the solar cell module in Example 9 will be described.

In the protective layer 11 of the solar cell module in Example 9, the first regions 12 covering a surface of the solar cell are arranged separately from each other. Polyimide tapes of the same type as the polyimide tape used to form the protective layer 5 in Example 1 were used for the first regions 12. The polyimide tapes were placed on the solar cell 3 such that the effective area fraction of the second region 13 was 33%. Specifically, the strip-shaped first regions 12 having a width of 6.0 mm were arranged into a stripe pattern with a separation distance of 1.45 mm. The effective area fraction of the second region 13 is a value when the effective distance is set to 0.2 mm as described later.

### [Comparative Example 1]

A solar cell module in Comparative Example 1 has the same structure as the structure of the solar cell module 300 shown in Fig. 3. The solar cell module in Comparative Example 1 was produced using the same procedure as in Example 1 except that the protective layer of the solar cell module in Example 1 was not formed.

### [Comparative Example 2]

A solar cell module in Comparative Example 2 has the same structure as the structure of the solar cell module 400 shown in Figs. 4A and 4B. The solar cell module in Comparative Example 2 was produced using the same procedure as in Example 1 except that the apertures in the protective layer of the solar cell module in Example 1 were not formed. Specifically, in Comparative Example 2, a polyimide tape with no apertures was used to form the protective layer.

### [Comparative Example 3]

A solar cell module in Comparative Example 3 has the same structure as the structure of the solar cell module 500 shown in Figs. 5A and 5B. The principal surface of the solar cell was bisected at the center. One of the regions was used as the first region, and a polyimide tape with no apertures was disposed thereon. No polyimide tape was disposed on the other region, and this region was used as the second region of the protective layer.

### [Evaluation method]

Each solar cell module was left to stand in an environment of 85°C and a dew point of -30°C for 300 hours (hereinafter referred to as "left to stand in the high-temperature environment for 300 hours"), and the characteristics of the solar cell before and after the solar cell was left to stand in the high-temperature environment were compared with each other. The characteristics of the solar cell were measured as follows. A halogen lamp ("BPS X300BA" manufactured by Bunkoukeiki Co. Ltd.) was used to irradiate the solar cell module with light at an illuminance of 100 mW/cm², and the current-voltage characteristics after stabilization were measured using "ALS440B" manufactured by BAS Inc. In this manner, the open circuit voltage (Voc), fill factor (FF), and conversion efficiency of the solar cell were determined. The retention ratio of each of the characteristic parameters of the solar cell is a relative value of the parameter after the cell is left to stand and is determined with the value of the parameter before the cell is left to stand set to 100. When the retention ratio of the Voc and the retention ratio of the FF were equal to or higher than 95%, the protective layer was judged as effective. When the retention ratio of the Voc and the retention ratio of the FF were equal to or higher than 99%, the protective layer was judged as highly effective. The results are shown in Table 1.

**[Table 1]**

| | Diameter of apertures mm | Center-to-center distance of apertures mm | Area fraction of second regions | Voc retention ratio % | FF retention ratio % | Conversion efficiency retention ratio % | Effective diameter of apertures mm | Effective area fraction of second regions |
|---|---|---|---|---|---|---|---|---|
| Example 1 | 0.71 | 2 | 10% | 99.2 | 99.6 | 98.8 | 1.11 | 24% |
| Example 2 | 1.01 | 2 | 20% | 99.8 | 99.7 | 99.5 | 1.41 | 39% |
| Example 3 | 1.43 | 2 | 40% | 99.9 | 99.6 | 99.5 | 1.83 | 66% |
| Example 4 | 1.75 | 2 | 60% | 99.9 | 99.6 | 99.5 | 2.15 | 91% |
| Example 5 | 0.30 | 1 | 7% | 99.7 | 99.9 | 99.6 | 0.70 | 38% |
| Example 6 | 1.90 | 4 | 18% | 99.3 | 99.8 | 99.1 | 2.30 | 26% |
| Example 7 | 0.50 | 2 | 5% | 97.6 | 99.9 | 97.5 | 0.90 | 16% |
| Example 8 | 1.82 | 2 | 65% | 99.9 | 97.8 | 97.7 | 2.22 | 97% |
| Example 9 | First regions are arranged separately from each other | | 24% | 99.6 | 99.7 | 99.3 | - | 33% |
| Comparative Example 1 | No first regions and no second regions (i.e., no protective layer) | | 100% | 72.7 | 49.8 | 36.2 | - | 100% |
| Comparative Example 2 | No second regions | | 0% | 94.5 | 99.5 | 94.0 | - | 0% |
| Comparative Example 3 | First region and second region are each not regions arranged separately from each other | | 50% | 97.9 | 63.2 | 61.9 | - | 50% |

First, attention is given to the FF retention ratio. In the solar cell module in Comparative Example 1 in which the protective layer 5 is not disposed, the FF retention ratio was 49.8%. In the solar cell module in Comparative Example 1, the FF was reduced to about one half after the solar cell module was left to stand in the high-temperature environment for 300 hours. This may be because, since the hole transport layer 7 of the solar cell 3 was in contact with the filler, delamination occurred at the interface between the photoelectric conversion layer 6 and the hole transport layer 7. In the solar cell modules in Examples 1 to 8, the FF retention ratio was equal to or more than 95%, and the effect on the FF retention ratio was obtained. In the solar cell modules in Examples 1 to 7 in which the area fraction of the second region is equal to or less than 60%, the FF retention ratio was equal to or more than 99%, and the effect on the FF retention ratio was sufficiently high. Fig. 6 is a graph showing the relation between the area fraction of the second regions and the FF retention ratio. The graph in Fig. 6 is based on the FF retention ratios of the solar cell modules in Examples 1 to 4, 7, and 8 and the solar cell modules in Comparative Examples 1 and 2.

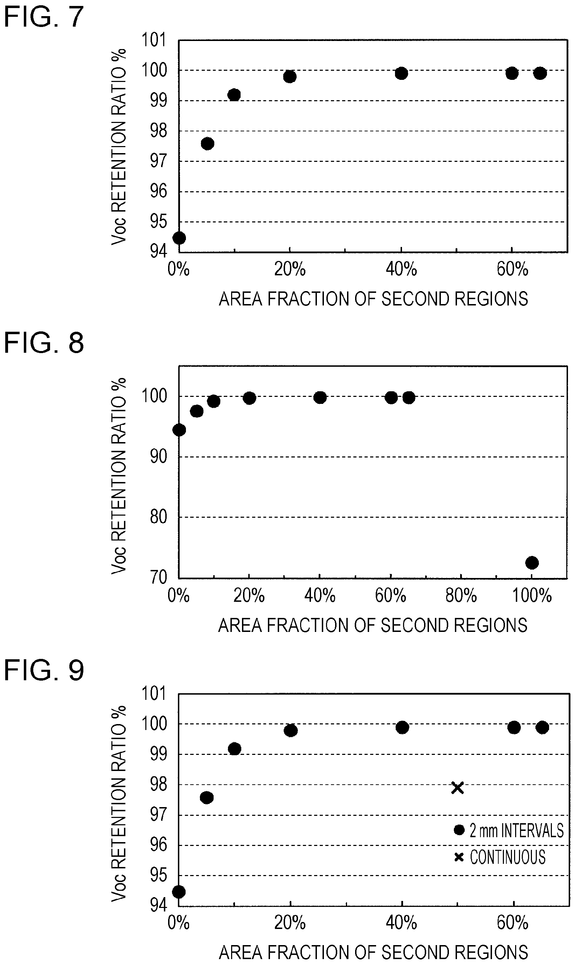

Next, attention is given to the Voc retention ratio. In the solar cell module in Comparative Example 2 in which the area fraction of the second regions is 0%, i.e., the protective layer has no second regions, the Voc retention ratio was less than 95%, and the Voc retention ratio was insufficient. This may be because, since no second regions were provided in the protective layer, desorbed gas was unlikely to pass through the protective layer, so that the desorbed gas stayed at high concentration on the surface of the solar cell. In the solar cell modules in Examples 1 to 8, the Voc retention ratio was equal to or more than 95%, and the effect on the Voc retention ratio was obtained. In the solar cell modules in Examples 1 to 6 and 8 in which the area fraction of the second regions is equal to or more than 7%, the Voc retention ratio was equal to or more than 99%, and the effect on the Voc retention ratio was sufficient. Fig. 7 is a graph showing the relation between the area fraction of the second regions and the Voc retention ratio. The graph in Fig. 7 is based on the Voc retention ratios of the solar cell modules in Examples 1 to 4, 7, and 8 and the solar cell module in Comparative Example 2.

In the solar cell module in Comparative Example 1, although the area fraction of the second regions is 100%, the Voc retention ratio is significantly low. This may be because of the interfacial delamination as described above, and this mechanism may differ from the mechanism of the deterioration due to the desorbed gas. Fig. 8 is a graph showing the relation between the area fraction of the second regions and the Voc retention ratio. The graph in Fig. 8 is based on the Voc retention ratios of the solar cell modules in Examples 1 to 4, 7, and 8 and the solar cell modules in Comparative Examples 1 and 2.

Next, attention is given to the arrangement of the apertures, i.e., the second regions, arranged separately from each other. In the solar cell module in Comparative Example 3 in which the first region and the second region are disposed continuously, although the area fraction of the second regions was 50%, the Voc retention ratio was lower than 99%. Fig. 9 is a graph showing the relation between the area fraction of the second regions and the Voc retention ratio. The graph in Fig. 9 is based on the Voc retention ratios of the solar cell modules in Examples 1 to 4, 7, and 8 and the solar cell modules in Comparative Examples 2 and 3. The reason for the reduction in the Voc retention ratio may be that, in the portion of the power generation region of the solar cell that was fully covered with the first region of the protective layer, the desorbed gas stayed at high concentration on the surface of the solar cell. It was therefore confirmed that it is necessary to arrange the second regions separately from each other.

However, the stay of the desorbed gas may be prevented when the distance to the apertures, i.e., the second regions, is equal to or less than the effective distance. Therefore, to examine the effective distance, "the effective area fraction of the apertures" was computed in consideration of the areas of regions obtained by extending the actual apertures by the effective distance in each of the Examples including Examples 5 and 6 in which the center-to-center distance differs from that in other Examples, and the relation between the effective area fraction of the apertures and the Voc retention ratio was examined. The effective area fraction of the apertures was computed with the effective distance set to 0.2 mm.

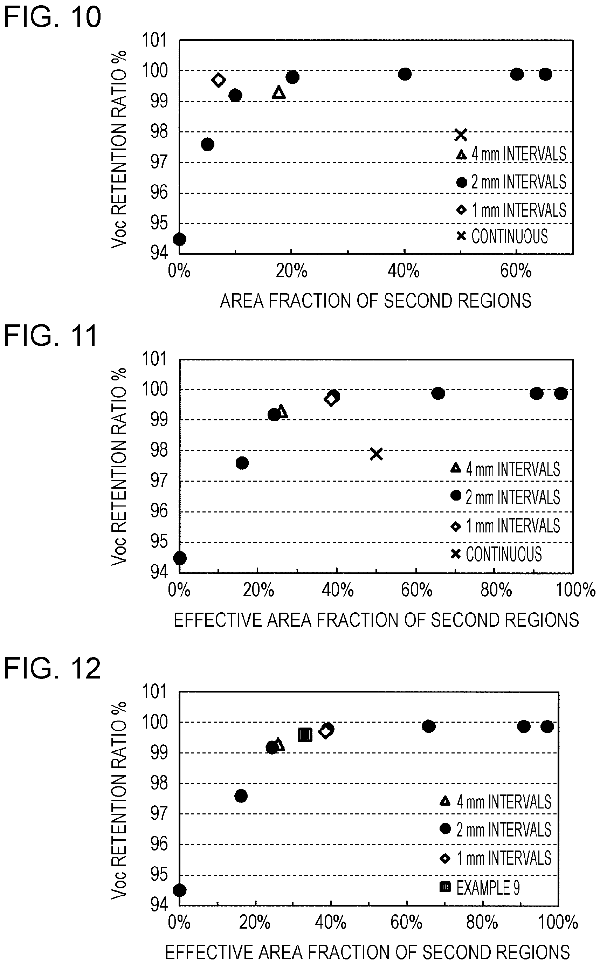

Fig. 10 is a graph showing the relation between the area fraction of the second regions and the Voc retention ratio. The graph in Fig. 10 is based on the Voc retention ratios of the solar cell modules in Examples 1 to 8 and the solar cell modules in Comparative Examples 2 and 3. Fig. 11 is a graph showing the relation between the effective area fraction of the second regions and the Voc retention ratio. The graph in Fig. 11 is based on the Voc retention ratios of the solar cell modules in Examples 1 to 8 and the solar cell modules in Comparative Examples 2 and 3. As shown in Fig. 10, the relation between the area fraction of the second regions and the Voc retention ratio in Examples 1 to 4 in which the center-to-center distance of the apertures is constant and is 2 mm slightly differs from those in Examples 5 and 6 in which the center-to-center distance of the apertures differs from that in Examples 1 to 4 (the center-to-center distance of the apertures is 1 mm in Example 5 and 4 mm in Example 6). However, as shown in Fig. 11, the correlation between the effective area fraction of the second regions determined with consideration given to the effective distance of 0.2 mm and the Voc retention ratio is very good even when the results in Examples 5 and 6 in which the center-to-center distances of the apertures differs from that in other Examples are included. Therefore, when the distance to the apertures is equal to or less than 0.2 mm, the stay of the desorbed gas may be prevented.

Fig. 12 is a graph showing the relation between the effective area fraction of the second regions and the Voc retention ratio. The graph in Fig. 12 is based on the Voc retention ratios of the solar cell modules in Examples 1 to 9 and the solar cell module in Comparative Example 2. The solar cell module in Example 9 differs in the form of the protective layer from the solar cell modules in Examples 1 to 8. However, as shown in Fig. 12, in the solar cell module in Example 9 and the solar cell modules in Examples 1 to 8, the correlation between the effective area fraction of the second regions determined with consideration given to the effective distance of 0.2 mm and the Voc retention ratio is very good.

### Industrial Applicability

The solar cell module of the present disclosure can be widely used for power generation devices that convert sunlight to electricity.

### Reference Signs List

1, 101 first substrate
2, 102 second substrate
3, 103 solar cell
3a principal surface
4, 104 filler
5, 11, 109, 110 protective layer
6, 106 photoelectric conversion layer
7, 107 hole transport layer
8, 108 electron transport layer
9, 12, 111 first region
10, 13, 112 second region
100, 200, 300, 400, 500 solar cell module

## Claims

1. A solar cell module comprising:
a first substrate;
a second substrate positioned so as to face the first substrate;
a solar cell disposed on the first substrate so as to be interposed between the first substrate and the second substrate;
a filler that fills a space between the first substrate and the second substrate; and
a protective layer disposed on a principal surface of the solar cell, the principal surface facing the second substrate,
wherein the solar cell has a multilayer structure including a photoelectric conversion layer containing a perovskite compound, a hole transport layer, and an electron transport layer,
wherein the protective layer contains a polyimide,
wherein the protective layer includes a first region that covers the principal surface of the solar cell and a second region in which the principal surface is exposed, and
wherein a plurality of the first regions or a plurality of the second regions are arranged separately from each other in the protective layer.

2. The solar cell module according to Claim 1, wherein, in the protective layer, the second region comprises a plurality of apertures that pass through the protective layer in a thickness direction thereof and are arranged separately from each other.

3. The solar cell module according to Claim 1 or 2, wherein a plurality of the first regions are arranged separately from each other in the protective layer.

4. The solar cell module according to any one of Claims 1 to 3, wherein an area fraction of the second region in the protective layer is equal to or more than 7% and equal to or less than 60%.

5. The solar cell module according to any one of Claims 1 to 4, wherein an effective area fraction of the second region in the protective layer is equal to or more than 24% and equal to or less than 91%.

6. The solar cell module according to any one of Claims 1 to 5, wherein the first substrate is transparent.

7. The solar cell module according to any one of Claims 1 to 6, wherein the electron transport layer contains titanium oxide.

8. The solar cell module according to any one of Claims 1 to 7, wherein the hole transport layer contains polytriallylamine.

9. The solar cell module according to any one of Claims 1 to 8, wherein the photoelectric conversion layer contains CH₃NH₃PbI₃.
